**Europäisches Patentamt**

**European Patent Office**

**Office européen des brevets**

(19)

(11) Veröffentlichungsnummer : **0 478 567 B1**

(12) **EUROPÄISCHE PATENTSCHRIFT**

(45) Veröffentlichungstag der Patentschrift :
26.10.94 Patentblatt 94/43

(21) Anmeldenummer : **90906991.6**

(22) Anmeldetag : **10.05.90**

(86) Internationale Anmeldenummer :
**PCT/EP90/00756**

(87) Internationale Veröffentlichungsnummer :
**WO 91/00524 10.01.91 Gazette 91/02**

(51) Int. Cl.⁵ : **G01R 19/25**

(54) **VERFAHREN UND ELEKTRISCHE ANORDNUNG ZUR MESSIGNALVERARBEITUNG.**

(30) Priorität : **23.06.89 DE 3920648**

(43) Veröffentlichungstag der Anmeldung :
**08.04.92 Patentblatt 92/15**

(45) Bekanntmachung des Hinweises auf die
Patenterteilung :
**26.10.94 Patentblatt 94/43**

(84) Benannte Vertragsstaaten :
**AT BE CH DE DK ES FR GB IT LI NL SE**

(56) Entgegenhaltungen :
**EP-A- 40 795**
**EP-A- 281 733**
**SU-A- 1 308 919**

(73) Patentinhaber : **SIEMENS
AKTIENGESELLSCHAFT
Wittelsbacherplatz 2
D-80333 München (DE)**

(72) Erfinder : **POPPINGER, Manfred
Ruhsteinweg 5
D-8521 Uttenreuth (DE)**
Erfinder : **SCHÖRNER, Reinhold
Wiesenstra e 27
D-8521 Gro enseebach (DE)**

**Beschreibung**

Die Erfindung bezieht sich auf ein Verfahren und eine Anordnung zum Messen einer Meßgröße gemäß dem Oberbegriff des Anspruchs 1 bzw. 3, die beispielsweise aus "IEE. 4th International Conference Proceedings of Transducers (1987)", Tokyo 1987, Seiten 17 bis 24, bekannt sind.

In der modernen Meßtechnik werden zunehmend elektrische Meßwertaufnehmer eingesetzt, bei denen die zu messende Größe, beispielsweise ein Magnetfeld, eine Beschleunigung oder ein Druck, als Frequenzänderung erfaßt wird. Solche frequenzanalogen Meßsignale können weitgehend fehlerfrei über längere Strecken übertragen werden und sind insbesondere für eine digitale Weiterverarbeitung geeignet.

Meßwertaufnehmer mit frequenzanalogen Meßsignalen können dadurch realisiert werden, daß das zunächst in Form einer analogen Spannung oder eines analogen Stromes vorliegende Meßsignal in ein frequenzanaloges Signal umgewandelt wird. Die Information über das die Meßgröße beinhaltende Meßsignal erfolgt mit Hilfe eines zusätzlichen elektronischen Schaltkreises, beispielsweise eines Spannungs-Frequenzwandlers.

Die Meßgröße kann auch direkt in ein frequenzanaloges Meßsignal umgewandelt werden. Bei einem bekannten Meßwertaufnehmer ist ein Halbleiter-Sensor zur Messung eines Druckes offenbart, bei dem auf einer druckempfindlichen Membran mehrere Ringoszillatoren angeordnet sind, deren Schwingungsfrequenzen vom Druck abhängig sind. Durch eine unterschiedliche Anordnung zweier Ringoszillatoren auf der Membran kann aufgrund der Anisotropie der piezoelektrischen Konstanten erreicht werden, daß sich für die verschiedenen Ringoszillatoren druckabhängige Frequenzänderungen unterschiedlichen Vorzeichens ergeben (europäische Patentschrift EP-B-O 040 795).

Ferner ist ein auf der Basis von Ringoszillatoren aufgebauter Magnetfeld-Sensor bekannt, bei dem aus zwei frequenzanalogen Meßsignalen eine Differenzfrequenz gebildet wird, um die Empfindlichkeit zu erhöhen und die Querempfindlichkeiten zu verringern (europäische Offenlegungsschrift EP-A-O 281 733). Durch die Bildung einer Differenzfrequenz kann jedoch der Einfluß von Querempfindlichkeiten, die durch Störgrößen wie beispielsweise Temperatur und Versorgungsspannung verursacht werden, nicht wirksam eliminiert werden.

Um ein von Störgrößen weitgehend unabhängiges Ausgangssignal zu erhalten, ist in der bereits genannten Druckschrift "IEE. 4th Int. Conf. Proc. of Transducers" (1987), Tokyo 1987, Seiten 17 bis 24, bereits vorgeschlagen worden, anstelle der Bildung einer Differenzfrequenz das Frequenzverhältnis der frequenzanalogen Meßsignale zweier Ringoszillatoren als Maß für die zu ermittelnde Meßgröße zu verwenden. Durch diese Maßnahme können die von der Versorgungsspannung und von der Temperatur verursachten Querempfindlichkeiten praktisch vollkommen eliminiert werden, wenn die beiden Ringoszillatoren in ihrer technologischen Beschaffenheit übereinstimmen. Diese Druckschrift "IEE. 4th Int. Conf. Proc. of Transducers" (1987), Tokyo 1987, Seiten 17 bis 24, bildet jeweils die Grundlage für den Oberbegriff der unabhängigen Ansprüche 1 und 3.

Durch die Bildung eines Frequenzverhältnisses wird jedoch eine unerwünschte Nichtlinearität erzeugt, die für die weitere Signalverarbeitung ungünstig ist.

Der Erfindung liegen nun die Aufgaben zugrunde, ein Verfahren und eine Anordnung zum Messen einer Meßgröße anzugeben, mit dem ein der Meßgröße entsprechendes elektrisches Meßsignal erzeugt wird, das von dieser unerwünschten Nichtlinearität weitgehend befreit und praktisch unabhängig von Störgrößen ist.

Die genannten Aufgaben werden erfindungsgemäß jeweils gelöst mit den Merkmalen der Ansprüche 1 bzw. 3. Da aus den frequenzanalogen Signalen eine Größe abgeleitet wird, zu deren Ermittlung nur Frequenzverhältnisse verwendet werden, sind die Störgrößen praktisch vollkommen eliminiert. Durch die Bildung der Differenz aus dem Frequenzverhältnis und seinem Kehrwert wird die Nichtlinearität verringert. Außerdem wird die Empfindlichkeit der elektrischen Meßanordnung vergrößert.

Vorteilhafte Ausgestaltungen des Verfahrens und der Anordnung gemäß der Erfindung ergeben sich aus den jeweils abhängigen Ansprüchen.

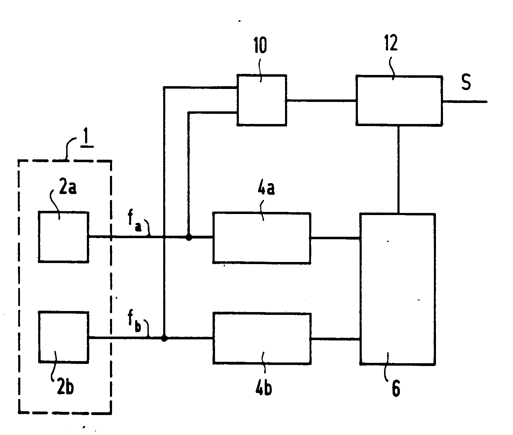

Zur weiteren Erläuterung der Erfindung wird auf die Zeichnung verwiesen, in deren einziger Figur eine besonders bevorzugte Meßanordnung gemäß der Erfindung in einem Blockschaltbild schematisch veranschaulicht ist.

Gemäß der Figur enthält eine Anordnung zum Messen einer Meßgröße einen Meßwertaufnehmer 1, der zur Umwandlung der Meßgröße in wenigstens zwei frequenzanaloge Signale zwei Oszillatorschaltkreise 2a und 2b enthält, deren Frequenzen $f_a$ bzw. $f_b$ unterschiedlich von der Meßgröße abhängen. In einer bevorzugten Ausführungsform enthalten die Oszillatorschaltkreise 2a und 2b als frequenzbestimmende und von der Meßgröße abhängige sensitive Elemente Halbleiterelemente, beispielsweise MIS-Transistoren, die vorzugsweise jeweils zu Ringoszillatoren zusammengefaßt sind. Die Frequenzen $f_a$ und $f_b$ der beiden Oszillatorschaltkreise 2a bzw. 2b hängen sowohl von Störgrößen $s_1$, $s_2$, .., $s_N$ als auch von der eigentlichen Meßgröße m ab und lassen sich für den Fall einer linearen Abhängigkeit der Frequenzen von der Meßgröße m durch die Beziehungen

$$f_a = f_{a0}(1 + am)\, g_1(s_1, s_2, \ldots s_N) \quad (1)$$
$$f_b = f_{b0}(1 + bm)\, g_2(s_1, s_2, \ldots s_N) \quad (2)$$

darstellen. Dabei bedeuten $f_{a0}$ und $f_{b0}$ die Grundfrequenzen der beiden Oszillatorschaltkreise 2a und 2b sowie a und b die Empfindlichkeiten, und die Funktionen $g_1$ und $g_2$ beschreiben die Abhängigkeit der Frequenzen von den Störgrößen. Für den Fall, daß technologiebedingte Variationen der Funktionen $g_1$ und $g_2$ beispielsweise durch unmittelbar benachbarte Anordnung auf dem gleichen Sensorchip vernachlässigt werden können, ergibt sich für das Frequenzverhältnis

$$\frac{f_a}{f_b} = \beta\, \frac{1 + am}{1 + bm} \quad (3)$$

mit $\beta = f_{a0}/f_{b0}$. Der Gleichung (3) ist zu entnehmen, daß in diesem Fall durch die Bildung eines Frequenzverhältnisses $f_a/f_b$ der Einfluß der Störgrößen vollständig eliminiert ist.

Eine Reihenentwicklung der Gleichung (3) ergibt dann bei Berücksichtigung linearer und quadratischer Glieder

$$f_a/f_b \approx \beta(1 + (a - b)m - (ab - b^2)m^2) \quad (4)$$

Die Empfindlichkeit wird somit gleich der Differenz der Empfindlichkeiten der einzelnen Oszillatorschaltkreise. Zusätzlich tritt jedoch mit dem quadratischen Term $m^2$ eine deutliche Nichtlinearität auf und dies trotz der angenommenen strengen Linearität der Frequenzänderungen der einzelnen Oszillatorschaltkreise. Der Wert dieser Nichtlinearität ist unter der Annahme gleicher absoluter Empfindlichkeiten für beide Oszillatorschaltkreise in linearer Näherung für $a = -b$ und einem Wert $m_{max}$ der Meßgröße am Meßbereichsende durch die Beziehung

$$NL \approx -0.25\, a\, m_{max} \quad (5)$$

gegeben.

Für einen Drucksensor mit einem Meßbereich von $10^5$ Pa und einer Empfindlichkeit von $a = 3.10^{-7}$ Pa$^{-1}$ der beiden Oszillatorschaltkreise 2a und 2b bedeutet dies eine Nichtlinearität von etwa 0,0075 für das Frequenzverhältnis $f_a/f_b$. Erfindungsgemäß ist deshalb vorgesehen, der Bestimmung der Meßgröße m anstelle des Frequenzverhältnisses $f_a/f_b$ die Differenz des Frequenzverhältnisses $f_a/f_b$ und seines Kehrwertes $f_b/f_a$ zugrundezulegen. Mit einem entsprechenden Meßsignal

$$S' = \frac{f_a}{f_b} - \frac{f_b}{f_a} \quad (6)$$

ergibt sich unter den gleichen Annahmen wie bei der Ableitung von Gleichung (5) die Beziehung

$$S' = \frac{\beta^2 - 1}{\beta} + \frac{\beta^2 + 1}{\beta}(a - b)m - \left(\frac{\beta^2 - 1}{\beta}ab - \beta a^2 + \frac{1}{\beta}b^2\right)m^2 \quad (7)$$

Für $a=-b$ erhält man dann für die Nichtlinearität NL näherungsweise die Beziehung

$$NL \approx 0.25\, \frac{\beta^2 - 1}{\beta^2 + 1}\, a m_{max} \quad (8)$$

Der Gleichung ist zu entnehmen, daß die Nichtlinearität des Meßsignales S' um den Faktor $\frac{\beta^2 - 1}{\beta^2 + 1}$ kleiner ist als die Nichtlinearität des einfachen Frequenzverhältnisses $f_a/f_b$ gemäß Gleichung (5). Für $\beta=1$ ergibt sich somit eine in erster Näherung verschwindende Nichtlinearität NL.

Darüber hinaus ist die Empfindlichkeit des Meßsignals S' um den Faktor $\frac{\beta^2 + 1}{\beta}$ gegenüber dem einfachen Frequenzverhältnis V vergrößert. Für $\beta=1$ ist die Empfindlichkeit des Meßsignales S' somit etwa doppelt so groß wie die Empfindlichkeit des einfachen Frequenzverhältnisses. Sie beträgt dann etwa das Vierfache der als identisch angenommenen Empfindlichkeiten der beiden Oszillatorschaltkreise. Außerdem ist in diesem Fall das Nullsignal vollständig unterdrückt.

Zur Ermittlung des aus der Differenz des Frequenzverhältnisses $f_a/f_b$ und seines Kehrwerts $f_a/f_b$ gebildeten Meßsignales S' ist gemäß der Figur eine elektronische Schaltung vorgesehen, bei der den Oszillatorschaltkreisen 2a und 2b jeweils ein Vorwahlzähler 4a und 4b zugeordnet ist. Die beiden Vorwahlzähler 4a und 4b sind mit einer Schaltlogik 6 verbunden, die in Abhängigkeit von den Steuerbefehlen, die von den Vorwahlzählern 4a und 4b zugeführt werden, einen Ergebniszähler 12 startet und stoppt. Erreicht beispielsweise der Vorwahlzähler 4a einen vorbestimmten Zählerinhalt A, so wird von ihm ein Steuerbefehl an die Schaltlogik 6 weitergeleitet, die den Ergebniszähler 12 startet. Erreicht danach der Vorwahlzähler 4b den gleichen vorbestimmten Zählerinhalt A, so wird über die Schaltlogik 6 der Ergebniszähler 12 gestoppt.

Die Ausgänge der Oszillatorschaltkreise 2a, 2b sind über einen Schaltkreis 10 mit dem Ergebniszähler 12 verbunden. Mit Hilfe des Schaltkreises 10, vorzugsweise ein EXKLUSIV-ODER-Gatter, wird aus den Ausgangssignalen der Oszillatorschaltkreise 2a und 2b ein Summenfrequenzsignal mit der Frequenz $f_a + f_b$ erzeugt. Dieses Summenfrequenzsignal wird dem Zähleingang des Ergebniszählers 12 zugeführt und in einem durch die Vorwahlzähler 4a und 4b und die Schaltlogik 6 festgelegten Zeitfenster vom Ergebniszähler 12 gezählt. Das Zeitfenster für den im Ergebniszähler 12 durchgeführten Zählvorgang beträgt dann $A/f_b - A/f_a$, so daß sich als Zählergebnis

$$ZE \; = \; INT \; (A(\frac{1}{f_b} \; - \; \frac{1}{f_a}) \; (f_a \; + \; f_b) \; ) \; = \; INT \; ( \; A(f_a/f_b \; - \; f_b/f_a) \; )$$

ergibt. Mit INT ist dabei der ganzzahlige Wert des analogen Ausdruckes innerhalb der Klammer bezeichnet. Das Zählergebnis ZE steht als Meßsignal S an einem Ausgang des Ergebniszählers 12 an. Dieses Meßsignal S ist mit dem gemäß Gleichung (6) durch die Differenz aus dem Frequenzverhältnis $f_a/f_b$ und dessen Kehrwert $f_b/f_a$ dargestellte Meßsignal S′ durch die Vorschrift S = INT (AS') verknüpft.

## Patentansprüche

1. Verfahren zum Messen einer Meßgröße, bei dem
   a) die Meßgröße mittels eines elektrischen Meßwertaufnehmers (1) in wenigstens zwei unterschiedliche frequenzanaloge Signale mit entsprechenden, von der Meßgröße unterschiedlich abhängenden Frequenzen $f_a$ und $f_b$ umgewandelt wird,
   **dadurch gekennzeichnet, daß**
   b) ein Meßsignal (S') für die Meßgröße hergeleitet wird, das durch die Differenz $f_a/f_b - f_b/f_a$ aus dem Verhältnis $f_a/f_b$ der beiden Frequenzen $f_a$ und $f_b$ und dem Kehrwert $f_b/f_a$ dieses Verhältnisses $f_a/f_b$ dargestellt wird.

2. Verfahren nach Anspruch 1, **dadurch gekennzeichnet, daß** die Herleitung des Meßsignals (S') für die Meßgröße folgende Verfahrensschritte umfaßt:
   a) ein erster Vorwahlzähler (4a) zählt das frequenzanaloge Signal der Frequenz $f_a$, und ein zweiter Vorwahlzähler (4b) zählt das frequenzanaloge Signal der Frequenz $f_b$;
   b) mittels eines Schaltkreises (10), dessen einer Eingang mit dem Eingang des ersten Vorwahlzählers (4a) und dessen zweiter Eingang mit dem Eingang des zweiten Vorwahlzählers (4b) elektrisch verbunden ist, wird ein Summenfrequenzsignal mit der Summenfrequenz $f_a + f_b$ der beiden Frequenzen $f_a$ und $f_b$ der frequenzanalogen Signale gebildet;
   c) ein mit seinem Eingang mit dem Ausgang des Schaltkreises (10) elektrisch verbundener Ergebniszähler (12) zählt dieses Summenfrequenzsignal der Summenfrequenz $f_a + f_b$;
   d) der Ergebniszähler (12) wird gestartet, wenn der Zählerinhalt des Vorwahlzählers (4a oder 4b) mit der höheren Frequenz $f_a$ oder $f_b$ einen vorbestimmten Zählerwert A erreicht;
   e) der Ergebniszähler (12) wird angehalten, wenn der Zählerinhalt des anderen Vorwahlzählers (4b bzw. 4a) mit der niedrigeren Frequenz $f_b$ bzw. $f_a$ denselben vorbestimmten Zählwert A erreicht;
   f) das Zählergebnis des Ergebniszählers (12) wird am Ausgang des Ergebniszählers (12) bereitgestellt und ist gleich dem ganzzahligen Wert des Produkts $A(f_a/f_b - f_b/f_a)$ aus dem vorbestimmten Zählerwert A und der das Meßsignal (S') darstellenden Differenz $f_a/f_b - f_b/f_a$ aus dem Verhältnis $f_a/f_b$ der beiden Frequenzen $f_a$ und $f_b$ und seinem Kehrwert $f_b/f_a$.

3. Anordnung zum Messen einer Meßgröße mit
   a) einem elektrischen Meßwertaufnehmer (1) zum Umwandeln der Meßgröße in wenigstens zwei unterschiedliche frequenzanaloge Signale mit von der Meßgröße unterschiedlich abhängenden Frequenzen $f_a$ und $f_b$,
   **dadurch gekennzeichnet, daß**
   b) signalverarbeitende Mittel (4a, 4b, 6, 10, 12) vorgesehen sind zum Herleiten eines Meßsignals (S'), das die Differenz $f_a/f_b - f_b/f_a$ aus dem Verhältnis $f_a/f_b$ der beiden Frequenzen $f_a$ und $f_b$ und dem Kehrwert $f_b/f_a$ dieses Verhältnisses $f_a/f_b$ darstellt.

4. Anordnung nach Anspruch 3, **dadurch gekennzeichnet,** daß die signalverarbeitenden Mittel zum Herleiten des Meßsignals (S') umfassen:
   a) jeweils einen Vorwahlzähler (4a, 4b) für jedes der frequenzanalogen Signale, der mit dem Meßwertaufnehmer (1) elektrisch verbunden ist und zum Zählen der Frequenz $f_a$ bzw. $f_b$ des zugehörigen frequenzanalogen Signals vorgesehen ist;
   b) einen mit dem Meßwertaufnehmer (1) elektrisch verbundenen Schaltkreis (10) zum Bilden eines Summenfrequenzsignals mit der Summenfrequenz $f_a + f_b$ der beiden Frequenzen $f_a$ und $f_b$ der frequenzanalogen Signale,
   c) einen mit dem Ausgang des Schaltkreises (10) elektrisch verbundenen und zum Zählen dessen Summenfrequenzsignals vorgesehenen Ergebniszähler (12),

d) eine mit dem jeweiligen Ausgang der Vorwahlzähler (4a und 4b) und dem Ergebniszähler (12) elektrisch verbundene Schaltlogik (6), die zum Starten des Ergebniszählers (12), wenn der Zählerinhalt des die höhere Frequenz zählenden Vorwahlzählers (4a oder 4b) einen vorbestimmten Zählerwert A erreicht, und zum Stoppen des Ergebniszählers (12), wenn der Zählerinhalt des die niedrigere Frequenz zählenden Vorwahlzählers (4b bzw. 4a) denselben vorbestimmten Zählerwert A erreicht, vorgesehen ist, wobei

e) am Ausgang des Ergebniszählers (12) das Zählergebnis des Ergebniszählers (12) ansteht, das gleich dem ganzzahligen Wert des Produkts $A(f_a/f_b - f_b/f_a)$ aus dem vorbestimmten Zählerwert A und der das Meßsignal (S') darstellenden Differenz $f_a/f_b - f_b/f_a$ aus dem Verhältnis $f_a/f_b$ der beiden Frequenzen $f_a$ und $f_b$ und seinem Kehrwert $f_b/f_a$ ist.

5. Anordnung nach Anspruch 4, **dadurch gekennzeichnet,** daß als Schaltkreis (10) ein EXKLUSIV- ODER-Gatter vorgesehen ist.

6. Anordnung nach einem der Ansprüche 3 bis 5, **dadurch gekennzeichnet,** daß die frequenzanalogen Signale eine gegensinnige Frequenzabhängigkeit von der Meßgröße zeigen.

7. Anordnung nach einem der Ansprüche 3 bis 6, **dadurch gekennzeichnet,** daß der Meßwertaufnehmer (1) als frequenzbestimmende und von der Meßgröße abhängige sensitive Elemente Halbleiterelemente enthält.

8. Anordnung nach Anspruch 7, **dadurch gekennzeichnet,** daß zur Umwandlung der Meßgröße in frequenzanaloge Signale aus Halbleiterelementen aufgebaute Ringoszillatoren vorgesehen sind.

9. Anordnung nach einem der Ansprüche 3 bis 8, **dadurch gekennzeichnet,** daß die signalverarbeitenden Mittel gemeinsam mit dem Meßwertaufnehmer (1) auf einem Halbleiter-Chip integriert sind.

## Claims

1. A method of measuring a quantity to be measured, wherein

a) the quantity to be measured is converted by means of an electrical transducer (1) into at least two different frequency-analogue signals with corresponding frequencies $f_a$ and $f_b$ dependent in different ways upon the quantity to be measured,

characterised in that

b) a measurement signal (S') for the quantity to be measured is derived, which signal is represented by the difference $f_a/f_b-f_b/f_a$ of the ratio $f_a/f_b$ of the two frequencies $f_a$ and $f_b$ and the inverse value $f_b/f_a$ of this ratio $f_a/f_b$.

2. A method as claimed in Claim 1, characterised in that the derivation of the measurement signal (S') for the quantity to be measured comprises the following process steps:

a) a first preselection counter (4a) counts the frequency-analogue signal of the frequency $f_a$, and a second preselection counter (4b) counts the frequency-analogue signal of the frequency $f_b$;

b) by means of a circuit (10), one input of which is electrically connected to the input of the first preselection counter (4a) and the second input of which is electrically connected to the input of the second preselection counter (4b), a sum frequency signal with the sum frequency $f_a + f_b$ of the two frequencies $f_a$ and $f_b$ of the frequency-analogue signals is formed;

c) a result counter (12), which is electrically connected by its input to the output of the circuit (10), counts this sum frequency signal of the sum frequency $f_a + f_b$;

d) the result counter (12) is started when the counter content of the preselection counter (4a or 4b) with the higher frequency $f_a$ or $f_b$ reaches a predetermined count value A;

e) the result counter (12) is stopped when the counter content of the other preselection counter (4b or 4a) with the lower frequency $f_b$ or $f_a$ reaches the same predetermined count value A;

f) the counting result of the result counter (12) is made available at the output of the result counter (12) and is equal to the whole-number value of the product $A(f_a/f_b - f_b/f_a)$ of the predetermined count value A and the difference $f_a/f_b - f_b/f_a$, representative of the measurement signal (S'), of the ratio $f_a/f_b$ of the two frequencies $f_a$ and $f_b$ and its inverse value $f_b/f_a$.

3.  An arrangement for measuring a quantity to be measured comprising:
    a) an electrical transducer (1) for converting the quantity to be measured into at least two different frequency-analogue signals with frequencies $f_a$ and $f_b$ dependent in different ways upon the quantity to be measured,
    characterised in that
    b) signal-processing means (4a, 4b, 6, 10, 12) are provided for deriving a measurement signal (S') which represents the difference $f_a/f_b - f_b/f_a$ of the ratio $f_a/f_b$ of the two frequencies $f_a$ and $f_b$ and the inverse value $f_b/f_a$ of this ratio $f_a/f_b$.

4.  An arrangement as claimed in Claim 3, characterised in that the signal-processing means for the derivation of the measurement signal (S') comprise:
    a) a respective preselection counter (4a, 4b) for each of the frequency-analogue signals which is electrically connected to the transducer (1) and is provided for counting the frequency $f_a$ and $f_b$ of the associated frequency-analogue signal;
    b) a circuit (10) which is electrically connected to the transducer (1) for forming a sum frequency signal with the sum frequency $f_a + f_b$ of the two frequencies $f_a$ and $f_b$ of the frequency-analogue signals,
    c) a result counter (12) which is electrically connected to the output of the circuit (10) and is provided for counting its sum frequency signal,
    d) a logic circuit (6) which is electrically connected to the respective output of the preselection counters (4a and 4b) and the result counter (12) and which is provided for starting the result counter (12) when the counter content of the preselection counter (4a or 4b) counting the higher frequency reaches a predetermined count value A, and for stopping the result counter (12) when the counter content of the preselection counter (4b or 4a) counting the lower frequency reaches the same predetermined count value A, wherein
    e) at the output of the result counter (12) the counting result of the result counter (12) occurs, which result is equal to the whole-number value of product $A(f_a/f_b - f_b/f_a)$ of the predetermined count value A and the difference $f_a/f_b - f_b/f_a$, representative of the measurement signal (S'), of the ratio $f_a/f_b$ of the two frequencies $f_a$ and $f_b$ and its inverse value $f_b/f_a$.

5.  An arrangement as claimed in Claim 4, characterised in that an exclusive-OR-gate is provided as circuit (10).

6.  An arrangement as claimed in one of Claims 3 to 5, characterised in that the frequency-analogue signals exhibit an opposite frequency dependence upon the quantity to be measured.

7.  An arrangement as claimed in one of Claims 3 to 6, characterised in that the transducer (1) contains semiconductor elements as frequency-determining, sensitive elements dependent upon the quantity to be measured.

8.  An arrangement as claimed in Claim 7, characterised in that ring oscillators constructed from semiconductor elements are provided for the conversion of the quantity to be measured into frequency-analogue signals.

9.  An arrangement as claimed in one of Claims 3 to 8, characterised in that the signal-processing means are integrated together with the transducer (1) on a semiconductor chip.

## Revendications

1.  Procédé pour mesurer une grandeur de mesure, selon lequel
    a) la grandeur de mesure est convertie, au moyen d'un capteur électrique de mesure (1), en au moins deux signaux analogues à des fréquences, qui possèdent des fréquences correspondantes $f_a$ et $f_b$, qui dépendent différemment de la grandeur de mesure,
    caractérisé par le fait que
    b) un signal de mesure (S') est obtenu pour la grandeur de mesure, signal qui est représenté par la différence $f_a/f_b - f_b/f_a$ entre le rapport $f_a/f_b$ des deux fréquences $f_a$ et $f_b$ et l'inverse $f_b/f_a$ de ce rapport $f_a/f_b$.

2.  Procédé suivant la revendication 1, caractérisé par le fait que l'obtention du signal de mesure (S') pour la grandeur de mesure comprend les étapes opératoires suivantes :

a) un premier compteur de présélection (4a) qui sélectionne le signal analogue à une fréquence et qui possède la fréquence $f_a$, et un second compteur de présélection (4b) compte le signal analogue à une fréquence et qui possède la fréquence $f_b$;

b) au moins un circuit (10), dont une entrée est raccordée à l'entrée du premier compteur de présélection (4a) et dont la seconde entrée est reliée électriquement à l'entrée du second compteur de présélection (4b), un signal de fréquence somme possédant une fréquence $f_a+f_b$ égale à la somme des deux fréquences $f_a$ et $f_b$ des signaux analogues à des fréquences est formé;

c) un compteur de résultats (12), dont la sortie est reliée électriquement par à la sortie du circuit (10), compte le signal de fréquence somme $f_a+f_b$;

d) le compteur de résultats (12) est déclenché lorsque le contenu du compteur de présélection (4a ou 4b) atteint, avec la fréquence supérieure $f_a$ ou $f_b$, une valeur de comptage prédéterminée A;

e) le compteur de résultats (12) est arrêté lorsque l'état de comptage de l'autre compteur de présélection (4b ou 4a) atteint, avec la fréquence inférieure $f_b$ ou $f_a$, la même valeur de comptage prédéterminée A;

f) le résultat de comptage du compteur de résultats (12) est préparé à la sortie du compteur de résultats (12) et est égal à la valeur entière du produit A ($f_a/f_b - f_b/f_a$) de la valeur de comptage prédéterminée A par la différence $f_a/f_b - f_b/f_a$ entre le rapport $f_a/f_b$ des deux fréquences $f_a$ et $f_b$ et sa valeur inverse $f_b/f_a$, la différence représentant le signal de mesure (S').

3. Dispositif pour mesurer une grandeur de mesure comportant

a) un capteur électrique de mesure (1) servant à convertir la grandeur de mesure en au moins deux signaux différents analogues à des fréquences qui possèdent les fréquences $f_a$ et $f_b$ qui dépendent différemment de la grandeur de mesure,

caractérisé par le fait que

b) il est prévu des moyens (4a,4b,6,10,12) de traitement des signaux, qui servent à obtenir un signal de mesure (S'), qui représente la différence $f_a/f_b - f_b/f_a$ entre le rapport $f_a/f_b$ des deux fréquences $f_a$ et $f_b$ et la valeur inverse $f_b/f_a$ de ce rapport $f_a/f_b$.

4. Dispositif suivant la revendication 3,

caractérisé par le fait que les moyens de traitement des signaux servant à obtenir le signal de mesure (S') comprennent :

a) respectivement un compteur de présélection (4a,4b) pour chacun des signaux analogues à des fréquences, ce compteur étant raccordé électriquement au capteur de mesure (1) et étant destiné à compter la fréquence $f_a$ ou $f_b$ du signal associé analogue à une fréquence;

b) un circuit (10), relié électriquement au capteur de mesure (1) pour former un signal de fréquence somme $f_a + f_b$, qui est la somme des fréquences $f_a$ et $f_b$ des signaux analogues à des fréquences;

c) un compteur de résultats (12) qui est relié électriquement à la sortie du circuit (10) et est prévu pour le comptage de son signal de fréquence somme,

d) un circuit logique (6) relié électriquement à la sortie respective du compteur de présélection (4a et 4b) et au compteur de résultats (12) et qui est prévu pour le démarrage du compteur de résultats (12), lorsque le contenu du compteur de présélection (4a ou 4b), qui compte la fréquence accrue, atteint une valeur de comptage prédéterminée A, et pour arrêter le compteur de résultats (12) lorsque le contenu du compteur de présélection (4b ou 4a), qui compte la fréquence la plus faible, atteint la même valeur de comptage prédéterminée A,

e) à la sortie du compteur de résultats (12) est présent le résultat de comptage du compteur de résultats (12), qui est égal à la valeur entière du produit A ($f_a/f_b - f_b/f_a$) de la valeur de comptage prédéterminée A par la différence $f_a/f_b - f_b/f_a$ entre le rapport $f_a/f_b$ des deux fréquences $f_a$ et $f_b$ et sa valeur inverse $f_b/f_a$, la différence représentant le signal de mesure (S').

5. Dispositif suivant la revendication 4,

caractérisé par le fait qu'il est prévu comme circuit (10) une porte OU-EXCLUSIF.

6. Dispositif suivant l'une des revendications 3 à 5, caractérisé par le fait que les signaux analogues en fréquence présentent une dépendance, en sens opposé, de la grandeur de mesure vis-à-vis de la fréquence.

7. Dispositif suivant l'une des revendications 3 à 6, caractérisé par le fait que le capteur de mesure (1) comporte des éléments à semiconducteurs en tant qu'éléments sensibles déterminant la fréquence et qui sont fonction de la grandeur de mesure.

8. Dispositif suivant la revendication 7, caractérisé par le fait que pour la conversion de la grandeur de mesure en des signaux analogues à des fréquence, il est prévu des oscillateurs en anneau constitués par des éléments à semiconducteurs.

9. Dispositif suivant l'une des revendications 3 à 8, caractérisé par le fait que les moyens de traitement des signaux sont intégrés conjointement avec le capteur de mesure (1) sur une microplaquette à semiconducteurs.